# EUROPEAN PATENT SPECIFICATION

(11) **EP 4 106 033 B1**
(45) Date of publication and mention of the grant of the patent: **18.11.2026**
(21) Application number: 20841851.7
(22) Date of filing: 19.03.2020
(51) Int. Cl.: H10K 50/844, H10K 59/80

(54) **OLED DISPLAY PANEL AND MANUFACTURING METHOD THEREFOR**
OLED-ANZEIGETAFEL UND HERSTELLUNGSVERFAHREN DAFÜR
PANNEAU D'AFFICHAGE DELO ET SON PROCÉDÉ DE FABRICATION

(30) Priority: 12.02.2020 CN 202010094201
(43) Date of publication of application: 21.12.2022
(73) Proprietor: Wuhan China Star Optoelectronics Semiconductor Display Technology Co., Ltd., Wuhan, Hubei 430079 (CN)
(72) Inventor: YE, Jian, Wuhan, Hubei 430079 (CN)
(74) Representative: Petraz, Gilberto Luigi
(86) International application number: PCT/CN2020/080186
(87) International publication number: WO 2021/159584

(56) References cited:
- CN-A- 108 520 895
- CN-A- 109 065 743
- CN-A- 109 300 910
- CN-A- 109 802 053
- CN-A- 110 854 297
- US-A1- 2018 026 226

## Description

### FIELD OF INVENTION

The present invention relates to the field of display technologies, and in particular, to an OLED display panel and a manufacturing method thereof.

### BACKGROUND OF INVENTION

Organic light emitting diodes (OLEDs) have advantages of light weight, wide viewing angles, fast response times, low temperature resistance, and high luminous efficiency, so they are regarded as next-generation new display technologies. In order to achieve packaging of OLED devices, thin film packaging has gradually become a mainstream packaging technology.

In thin-film packaging structures, an inorganic/organic/inorganic overlapping film layer structure is often used as a water-blocking and oxygen-blocking layer to prevent an intrusion of external water vapor and oxygen. However, due to fluidity of organic layer material, when an organic layer is formed by an inkjet printing method, the organic layer material easily diffuses and overflows, resulting in poor packaging effect. CN 109802053 A and CN 108520895 A are relevant prior arts and relate to the field of the OLED display technology field. CN 109802053 A relates to a display panel including a sealant. The sealant is disposed around a display area and located between a first inorganic layer and a second inorganic layer in a non-display area, contacting both the first inorganic layer and the second inorganic layer. Through the melting and resolidification of the sealant, the adhesion between the first inorganic layer, the second inorganic layer, and the sealant can be enhanced, thereby increasing the lifespan of the display panel. CN 108520895 A relates to a display panel including a substrate, a pixel array, a composite insulation layer, and an encapsulation layer. The composite insulating layer includes a first insulating layer and a second insulating layer, wherein the second insulating layer is located between the first insulating layer and the substrate, and a trench penetrates through the first insulating layer and the second insulating layer. An encapsulation layer is located on the pixel array and the composite insulating layer, and the encapsulation layer overlaps with the trench.

### TECHNICAL PROBLEM

The present invention provides an OLED display panel and a manufacturing method thereof. By defining a notch on a first inorganic layer in a second region around a periphery of a display region, the notch can accommodate flowable organic materials, so that inkjet printed organic materials have a greatly reduced flow velocity at the periphery of the display region, which can effectively prevent the organic materials from diffusing and overflowing, thereby improving packaging effect of a thin film packaging layer.

### TECHNICAL SOLUTION

An embodiment of the present invention provides an OLED display panel and a manufacturing method thereof, so as to solve a technical problem that an organic layer material in a thin film packaging structure easily diffuses and overflows and reduces the packaging effect.

The present invention provides an OLED display panel comprising:
a substrate comprising a display region, a first region disposed around the display region, and a second region disposed between the display region and the first region, wherein the second region is disposed around the display region;
a light-emitting function layer disposed on the display region;
a retaining wall disposed on the first region; and
a thin film packing layer disposed on the light emitting functional layer and extending to the retaining wall through the second region;
wherein the thin film packing layer comprises a first inorganic layer, an organic layer, and a second inorganic layer disposed in a stack, and a plurality of notches are defined in the first inorganic layer disposed in the second region;
wherein all of the notches are filled with material of the organic layer;
wherein the second region comprises at least two sub-regions surrounding the display region, the at least two sub-regions comprise a peripheral sub-region close to the display region and an edge sub-region away from the display region, multiple ones of the notches are defined in the peripheral sub-region, and multiple ones of the notches are defined in the edge sub-region;
wherein all of the notches are spaced from the light-emitting functional layer, a bottom of the notch in the peripheral sub-region is spaced from the substrate by a portion of the first inorganic layer, and the notches in the edge sub-region extend through the first inorganic layer and into the substrate.

In the OLED display panel provided in the present invention, the notches are disposed at intervals along a direction surrounding the display region.

In the OLED display panel provided in the present invention, the display region comprises a first diagonal corner portion and a second diagonal corner portion disposed opposite to each other, and a third diagonal corner portion and a fourth diagonal corner portion disposed opposite to each other; and
the first diagonal corner portion, the second diagonal corner portion, the third diagonal corner portion, and the fourth diagonal corner portion are correspondingly provided with the notches, wherein the notches arranged corresponding to the first diagonal corner portion, the second diagonal corner portion, the third diagonal corner portion, and the fourth diagonal corner portion are arc-shaped at locations facing the first diagonal corner portion, the second diagonal corner portion, the third diagonal corner portion, and the fourth diagonal corner portion.

In the OLED display panel provided in the present invention, the display region further comprises a first end portion, a second end portion, a third end portion, and a fourth end portion, the first end portion is disposed between the first diagonal corner portion and the fourth diagonal corner portion, the second end portion is disposed between the first diagonal corner portion and the third diagonal corner portion, the third end portion is disposed between the third diagonal corner portion and the second diagonal corner portion, and the fourth end portion is disposed between the second diagonal corner portion and the fourth diagonal corner portion; and
the first end portion, the second end portion, the third end portion, and the fourth end portion are correspondingly provided with the notches.

In the OLED display panel provided in the present invention, on any of the at least one sub-region, each of barrier spacers is between the adjacent notches, and the barrier spacers on the adjacent sub-regions are spaced apart, wherein the barrier spacers are staggered from each other along a direction surrounding the display region.

In the OLED display panel provided in the present invention, a thickness of the first inorganic layer is 1 µm to 2 µm, and a thickness of the organic layer is 4 µm to 10 µm.

The present invention further provides a manufacturing method of an OLED display panel, comprising following steps:
providing a substrate, wherein the substrate comprises a display region, a first region disposed around the display region, and a second region disposed between the display region and the first region, and the second region is disposed around the display region;
forming a light-emitting functional layer on the display region and forming a retaining wall on the first region;
forming a thin film packing layer on the light-emitting functional layer, wherein the thin film packing layer extends to the retaining wall through the second region;
performing an image process on the first inorganic layer disposed in the second region to form a plurality of notches; and
forming an organic layer and a second inorganic layer sequentially on the first inorganic layer;
wherein a plurality of notches are defined in the first inorganic layer disposed in the second region, and all of the notches are filled with material of the organic layer;
wherein the second region comprises at least two sub-regions surrounding the display region, the at least two sub-regions comprise a peripheral sub-region close to the display region and an edge sub-region away from the display region, multiple ones of the notches is defined in the peripheral sub-region, and multiple ones of the notches are defined in the edge sub-region;
wherein the step of forming the thin film packing layer on the light-emitting functional layer comprises: wherein the thin film packing layer comprises a first inorganic layer, an organic layer, and a second inorganic layer disposed in a stack, and performing an image process on the first inorganic layer disposed in the second region to form a notch before forming the organic layer.

In the manufacturing method of the OLED display panel provided in the present invention, the notches are disposed at intervals along a direction surrounding the display region.

In the manufacturing method of the OLED display panel provided in the present invention, the display region comprises a first diagonal corner portion and a second diagonal corner portion disposed opposite to each other, and a third diagonal corner portion and a fourth diagonal corner portion disposed opposite to each other; and the first diagonal corner portion, the second diagonal corner portion, the third diagonal corner portion, and the fourth diagonal corner portion are correspondingly provided with the notches, wherein the notches arranged corresponding to the first diagonal corner portion, the second diagonal corner portion, the third diagonal corner portion, and the fourth diagonal corner portion are arc-shaped at locations facing the first diagonal corner portion, the second diagonal corner portion, the third diagonal corner portion, and the fourth diagonal corner portion.

In the manufacturing method of the OLED display panel provided in the present invention, the display region further comprises a first end portion, a second end portion, a third end portion, and a fourth end portion, the first end portion is disposed between the first diagonal corner portion and the fourth diagonal corner portion, the second end portion is disposed between the first diagonal corner portion and the third diagonal corner portion, the third end portion is disposed between the third diagonal corner portion and the second diagonal corner portion, and the fourth end portion is disposed between the second diagonal corner portion and the fourth diagonal corner portion; and the first end portion, the second end portion, the third end portion, and the fourth end portion are correspondingly provided with the notches.

In the manufacturing method of the OLED display panel provided in the present invention, on any of the at least one sub-region, each of barrier spacers is between the adjacent notches, and the barrier spacers on the adjacent sub-regions are spaced apart.

In the manufacturing method of the OLED display panel provided in the present invention, a thickness of the first inorganic layer is 1 µm to 2 µm, and a thickness of the organic layer is 4 µm to 10 µm.

### BENEFICIAL EFFECT

The present invention provides an OLED display panel and a manufacturing method thereof. By defining a notch on a first inorganic layer in a second region around a periphery of a display region, the notch can accommodate flowable organic materials, so that inkjet printed organic materials have a greatly reduced flow velocity at the periphery of the display region, which allows the organic materials to solidify and form an organic layer before they overflow the retaining wall, effectively preventing the organic materials from diffusing and overflowing, and thereby improving packaging effect of the thin film packaging layer.

### DESCRIPTION OF DRAWINGS

In order to more clearly illustrate the embodiments or the technical solutions in the prior art, a brief introduction of the drawings used in the embodiments or the prior art description will be briefly described below. Obviously, the drawings in the following description are only some of the embodiments of the invention, and those skilled in the art can obtain other drawings according to the drawings without any creative work.
FIG. 1 is a first schematic structural view of an OLED display panel according to a non-claimed embodiment of the present invention.
FIG. 2 is a schematic structural view of a light-emitting functional layer in FIG. 1.
FIG. 3 is a first schematic plan view of the OLED display panel according to a non-claimed embodiment of the present invention.
FIG. 4 is a second schematic plan view of the OLED display panel according to a non-claimed embodiment of the present invention.
FIG. 5 is a third schematic plan view of the OLED display panel according to a non-claimed embodiment of the present invention.
FIG. 6 is a fourth schematic plan view of the OLED display panel according to a non-claimed embodiment of the present invention.
FIG. 7 is a second schematic structural view of the OLED display panel according to a non-claimed embodiment of the present invention.
FIG. 8 is a third schematic structural view of the OLED display panel according to a non-claimed embodiment of the present invention.
FIG. 9 is a fourth schematic structural view of the OLED display panel according to a non-claimed embodiment of the present invention.
FIG. 10 is a fifth schematic structural view of the OLED display panel according to one embodiment of the present invention.
FIG. 11 is a fifth schematic plan view of the OLED display panel according to one embodiment of the present invention.
FIG. 12 is a flowchart of a manufacturing method of the OLED display panel according to one embodiment of the present invention.

### DETAILED DESCRIPTION OF PREFERRED EMBODIMENTS

The technical solution in the embodiments of the present invention will be clearly and completely described below with reference to the accompanying drawings in the embodiments of the present invention. It is to be understood that the described embodiments are merely exemplary of the invention, and not restrictive of the full scope of the invention. All other embodiments, which can be obtained by a person skilled in the art without inventive step based on the embodiments of the present invention, are within the scope of the present invention.

In the description of the present invention, it should be understood that the terms "first" and "second" are used for descriptive purposes only and are not to be construed as indicating or implying relative importance or implicitly indicating the number of technical features indicated. Thus, features defined as "first", "second", may explicitly or implicitly include one or more of the described features, and thus cannot be understood as a limitation on the present invention.

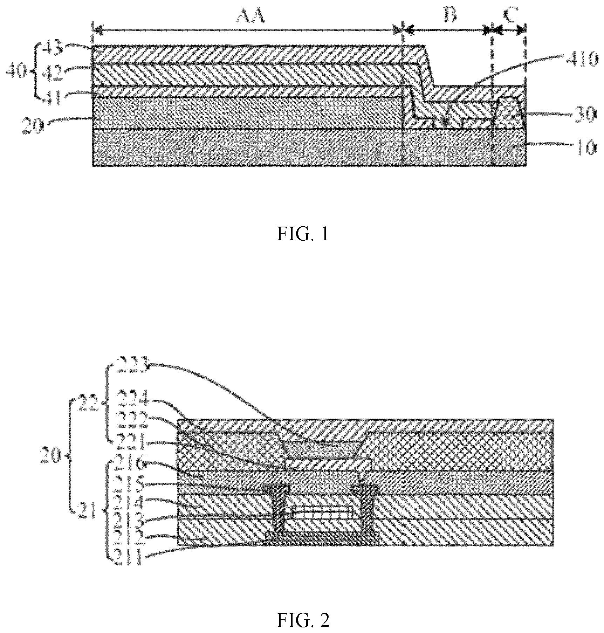

Please refer to FIG. 1 and FIG. 2, a non-claimed embodiment of the present invention provides an OLED display panel. The OLED display panel comprises a substrate 10 comprising a display region AA, a first region C disposed around the display region AA, and a second region B disposed between the display region AA and the first region C, wherein the second region B is disposed around the display region AA; a light-emitting functional layer 20 disposed on the display region AA; a retaining wall 30 disposed on the first region C; and a thin film packing layer 40 disposed on the light emitting functional layer 20 and extending to the retaining wall 30 through the second region B; wherein the thin film packing layer 40 comprises a first inorganic layer 41, an organic layer 42, and a second inorganic layer 43 disposed in a stack, and a notch 410 is defined in the first inorganic layer 41 disposed in the second region B.

The substrate 10 may be a polyimide (PI) flexible substrate (polyimide film). The substrate 10 may be composed of one or more PI flexible substrates, which is not limited in the present invention.

The light-emitting functional layer 20 comprises an array layer 21 and a light-emitting layer 22 which are arranged in a stack. Specifically, the array layer 21 comprises, but is not limited to, an active layer 211, a first dielectric insulating layer 212, a gate metal layer 213, a second dielectric insulating layer 214, a source-drain metal layer 215, and a planarization layer 216, which are arranged in a stack. The light emitting layer 22 comprises, but is not limited to, a pixel electrode layer 221, a pixel definition layer 222, a light-emitting material layer 223, and a cathode layer 224, which are arranged in a stack. The specific structure of each film layer is the conventional prior art, which is not described in the present invention.

The retaining wall 30 is disposed around a periphery of the display region AA. The retaining wall 30 may be disposed on a same layer as a functional film layer in the light-emitting functional layer 20, such as the pixel definition layer 222. The retaining wall 30 can also be disposed on the same layer as several functional film layers in the light-emitting functional layer 20, such as the planarization layer 216 and the pixel definition layer 222 that are arranged in a stack. The retaining wall 30 may also be formed by stacking other inorganic materials and/or organic materials separately; the present invention does not specifically limit thereto.

The thin film packing layer 40 can comprise a film layer structure having multilayer with inorganic/organic/inorganic overlapping film layers. In the embodiment of the present invention, the thin film packing layer 40 comprises a first inorganic layer 41, an organic layer 42, and a second inorganic layer 43 which are arranged in a stack as an example for description. The first inorganic layer 41 and the second inorganic layer 43 may have a single-layer or multi-layer structure of silicon dioxide, silicon nitride, silicon oxynitride, or amorphous silicon, so as to prevent intrusion of external water vapor and oxygen. The organic layer 42 may be one or more of acrylic resin, polycarbonate, and polystyrene. The organic layer 42 may be used to slow down stresses in the first inorganic layer 41 and the second inorganic layer 43, thereby enhancing flexibility of the OLED display panel. The organic layer 42 is usually formed by an inkjet printing process. However, when the organic layer 42 is formed by inkjet printing, a material of the organic layer 42 has a certain fluidity before forming the fixedly formed organic layer 42 and flows from the display region AA to the retaining wall 30.

The notch 410 is defined in the second region B between the display region AA and the retaining wall 30 and can accommodate a certain amount of the organic materials to prevent the organic materials from overflowing the retaining wall. In addition, a shape and number of the notch 410 can be set according to the actual situation. For example, the notch 410 may be a bar shape, an arc shape, or triangular; the notch 410 may be provided as one or may be provided as multiple. The present invention does not limit thereto.

In the embodiment of the present invention, the notch 410 is disposed on the first inorganic layer 41 in the second region B around the display region AA, and the notch 410 can accommodate the flowable organic materials, so that the flow velocity of the inkjet printed organic materials in the peripheral region of the display region AA is greatly reduced, and the organic materials are solidified to form the organic layer 42 before overflowing the retaining wall 30. This effectively prevents diffusion and overflow of the organic materials, thereby improving packaging effect of the thin film packaging layer 40.

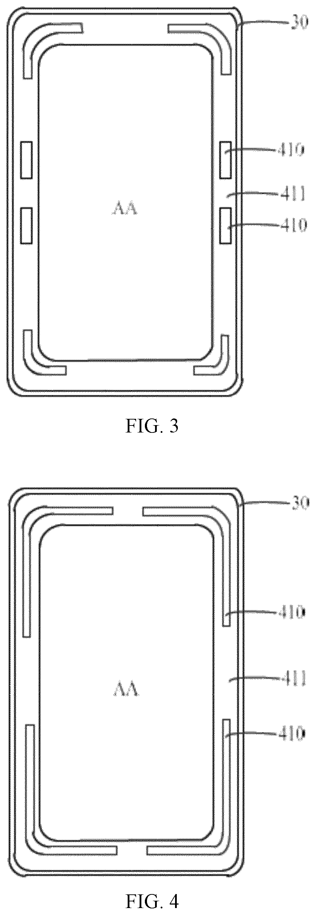

Specifically, please refer to FIG. 3, in a non-claimed embodiment of the present invention, a plurality of notches 410 are defined in the second region B, and the plurality of notches 410 are spaced apart along a direction surrounding the display region AA. Each of a plurality of first spacers 411 is between the adjacent notches 410. The first spacer 411 is the remaining first inorganic layer 41. When the notch 410 accommodates the flowable organic materials, the first spacer 411 can extend a path for water and oxygen to intrude the light-emitting functional layer 20 through the organic materials, thereby effectively improving package reliability.

In some embodiments, please continue to refer to FIG. 3 of the non-claimed embodiment. In a direction surrounding the display region AA, a sum of lengths of the plurality of notches 410 is less than a sum of lengths of the plurality of first spacers 411. While the notch 410 has buffering effect on the flow of the organic materials, the first spacer 411 can be used to effectively extend the path for water and oxygen to intrude the light-emitting functional layer 20 through the organic materials, thereby improving the package reliability. It should be noted that, on this basis, a number or specific distribution of each notch 410 and each first spacer 411 is not specifically limited in the embodiment of the present invention.

In some embodiments, please refer to FIG. 4 of a non-claimed embodiment. In the direction surrounding the display region AA, the sum of the lengths of the plurality of notches 410 is greater than the sum of the lengths of the plurality of first spacers 411. The notch 410 can have more space to accommodate the organic materials, which can more effectively buffer the flow of the organic materials, thereby preventing the overflow of the organic materials. Meanwhile, the remaining first spacer 411 can also play a certain effect of blocking water and oxygen. It should be noted that, on this basis, the number or specific distribution of each notch 410 and each first spacer 411 is not specifically limited in the embodiment of the present invention.

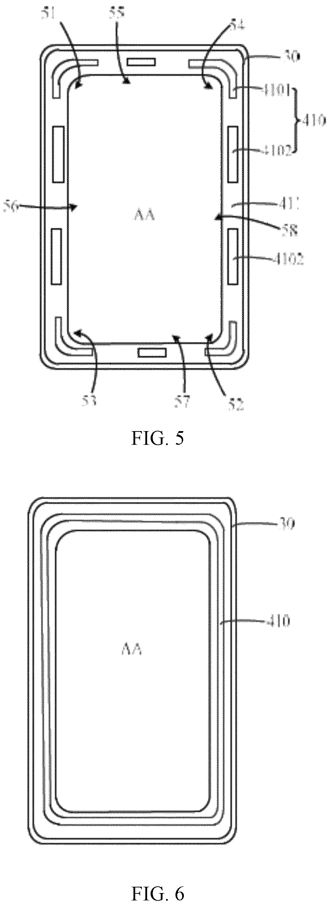

In the embodiment of the present invention, please refer to FIG. 5 of a non-claimed embodiment, the display region AA comprises a first diagonal corner portion 51 and a second diagonal corner portion 52 disposed opposite to each other, and a third diagonal corner portion 53 and a fourth diagonal corner portion 54 disposed opposite to each other. The first diagonal corner portion 51, the second diagonal corner portion 52, the third diagonal corner portion 53, and the fourth diagonal corner portion 54 are correspondingly provided with the notches 410.

Accordingly, the display region AA further comprises a first end portion 55, a second end portion 56, a third end portion 57, and a fourth end portion 58. The first end portion 55 is disposed between the first diagonal corner portion 51 and the fourth diagonal corner portion 54. The second end portion 56 is disposed between the first diagonal corner portion 51 and the third diagonal corner portion 53. The third end portion 57 is disposed between the third diagonal corner portion 53 and the second diagonal corner portion 52 The fourth end portion 58 is disposed between the second diagonal corner portion 52 and the fourth diagonal corner portion 54. The first end portion 55, the second end portion 56, the third end portion 57, and the fourth end portion 58 are correspondingly provided with the notches 410.

Further, the notch 410 comprises a first notch 4101 and a second notch 4102. The first notch 4101 is arc-shaped, and the second notch 4102 is strip-shaped. The first diagonal corner portion 51, the second diagonal corner portion 53, the third diagonal corner portion 53, and the fourth diagonal corner portion 54 are correspondingly provided with the first notches 4101. The first end portion 55, the second end portion 56, the third end portion 57, and the fourth end portion 58 are correspondingly provided with the second notches 4102. It can be understood that, for a conventional display panel, in order to obtain an aesthetic effect, the four corners of the rectangular display region AA are usually set as arc-shaped corners. Therefore, in the second region B, first arc-shaped notches 4101 corresponding to the first diagonal corner portion 51, the second diagonal corner portion 52, the third diagonal corner portion 53, and the fourth diagonal corner portion 54 are provided. The notches 4101 correspond to the four corner shapes of the display region AA, which can effectively maintain uniformity of the flow of the organic materials at the corners of the display region AA, thereby ensuring thickness consistency of the organic layer 42.

Further, the second notches 4102 disposed corresponding to the first end portion 55 and the third end portion 57 are symmetrically distributed; the second notches 4102 disposed corresponding to the second end portion 56 and the fourth end portion 58 are symmetrically distributed. The distribution of the second notches 410 corresponding to the first diagonal corner portion 51, the second diagonal corner portion 52, the third diagonal corner portion 53, and the fourth diagonal corner portion 54 is the same. The symmetrical arrangement of the notches 410 allows the organic materials to flow at the same speed toward the periphery of the display region AA during the flow process, and the thickness of the organic layer 42 formed at the end is uniform, thereby improving the flexibility of the OLED display panel and effectively relieving stress in the first inorganic layer 41.

Please refer to FIG. 6 of the non-claimed embodiment, in the embodiment of the present invention, only one notch 410 is defined in the second region B, and the notch 410 is disposed along a direction surrounding the display region AA. Setting the notch 410 around the entire display region AA can effectively increase the space for containing the organic materials, thereby improving the package reliability and effectively delaying the overflow of the organic materials.

In addition, in the embodiment of the present invention, a thickness of the first inorganic layer 41 is 1 µm to 2 µm. A thickness of the organic layer 42 is 4 µm to 10 µm. The notch 410 is a groove, or the notch 410 is a through hole passing through the first inorganic layer 41.

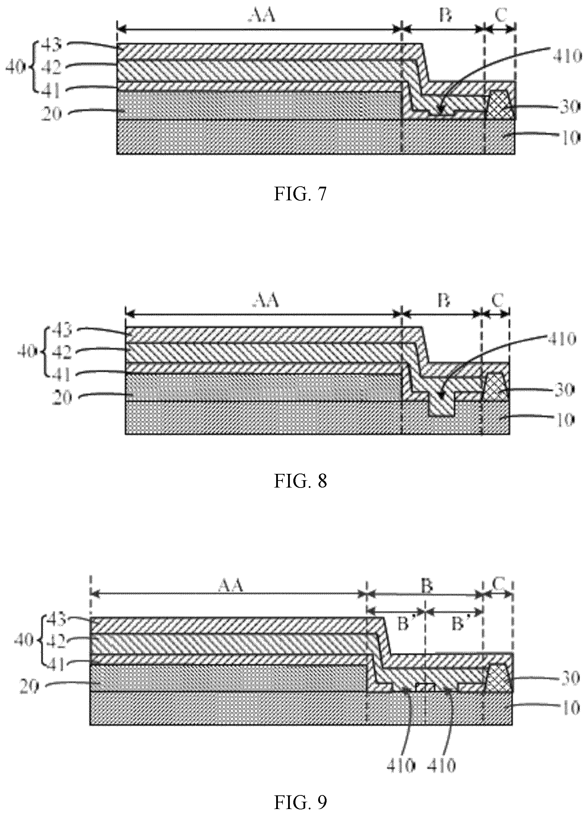

Specifically, please refer to FIG. 7 of the non-claimed embodiment, when a depth of the notch 410 is less than the thickness of the first inorganic layer 41 in a direction perpendicular to the substrate 10, the notch 410 is shown as a groove on the first inorganic layer 41. Meanwhile, the notch 410 does not pass through the first inorganic layer 41. After the notch 410 is filled with the organic materials, the first inorganic layer 41 remaining under the notch 410 can effectively prevent outside water and oxygen from eroding the light-emitting functional layer 42 through the organic materials in the notch 410, thereby improving the package reliability.

Further, when the notch 410 is a groove that does not pass through the first inorganic layer 41, only one notch 410 may be defined in the second region B, and the notch 410 is disposed along a direction surrounding the display region AA. Meanwhile, because the first inorganic layer 41 remaining under the notch 410 can effectively block water and oxygen, disposing the entire notch 410 surrounding the display region AA can increase the space for accommodating the organic materials, thereby improving the package reliability and further preventing the diffusion and overflow of the organic materials.

Please refer to FIG. 1 and FIG. 8 of the non-claimed embodiment, when the notch 410 is equal to or greater than the thickness of the first inorganic layer 41 in a direction perpendicular to the substrate 10, the notch 410 is shown as a through hole in the first inorganic layer 41. Specifically, the notch 410 only pass through the first inorganic layer 41, or the notch 410 passes through the first inorganic layer 41 and extends to the substrate 10. When the notch 410 extends to the substrate 10, the space where the notch 410 accommodates the organic materials can be increased, and the organic materials can be more effectively prevented from overflowing the retaining wall 30 through the second region B.

In addition, in the embodiment of the present invention, the first inorganic layer 41 and/or the second inorganic layer 43 extend to the retaining wall 30 and completely cover the retaining wall 30. It can prevent outside water and oxygen from invading into the OLED display panel through the side of the retaining wall 30 away from the display region AA, thereby further improving the package reliability of the thin film packaging layer 40.

Please refer to FIG. 9, in some non-claimed embodiments, the second region B comprises at least one sub-region B', and the sub-region B' is disposed around the display region AA. Multiple notches 410 are correspondingly defined in any of the at least one sub-region B'. By disposing a plurality of sub-regions B' with notches 410 around the periphery of the display region AA, after the notches 410 near the display region AA are filled by the flowing organic materials, the notches 410 in the adjacent sub-regions B' can further accommodate the organic materials and reduce risk of the organic materials overflowing the retaining wall 30.

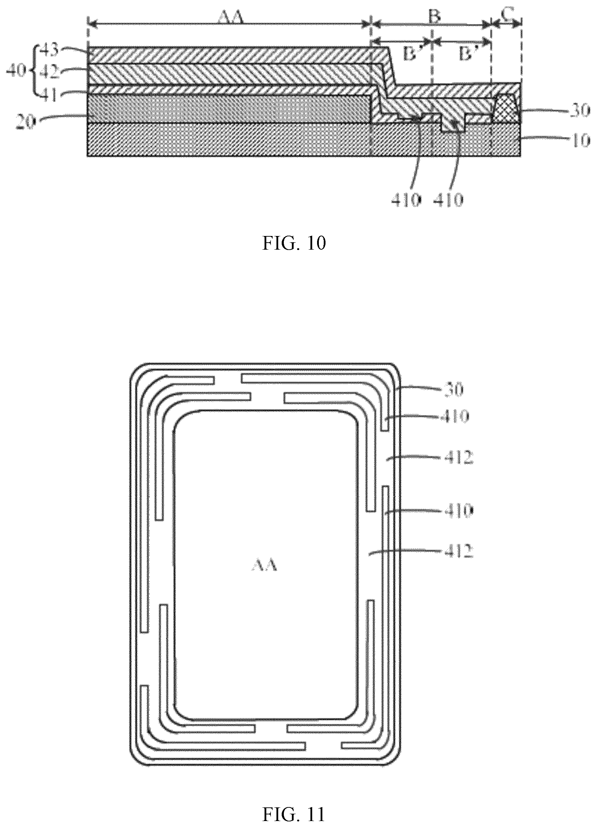

It should be noted that the notches 410 in the plurality of sub-regions B' are set as the above-mentioned grooves or through holes; the plurality of sub-regions B' are each provided with one notch 410 surrounding the display region AA or multiple notches 410 arranged at intervals. Specifically, please refer to FIG. 10, in the embodiment of the present invention, two sub-regions B' are disposed on the periphery of the display region AA, and the notch 410 near a boundary of the display region AA is set as a groove. The notch 410 far from the boundary of the display region AA is set as a through hole extending to the substrate 10 as an example for illustration. After the notch 410 near the boundary of the display region AA is filled with the organic materials, the first inorganic layer 41 remaining under the notch 410 can effectively prevent outside water and oxygen from eroding the light-emitting functional layer 42 through the organic materials in the notch 410. Meanwhile, the notch 410 away from the boundary of the display region AA accommodates more organic materials, which can further prevent the organic materials from flowing out of the retaining wall 30. The embodiment of the present invention can effectively improve the package reliability while effectively preventing the overflow of the organic materials.

Further, please refer to FIG. 11, on any of the at least one sub-region B', each of barrier spacers 412 is between the adjacent notches 410, and the barrier spacers 412 on the adjacent sub-regions B' are spaced apart. Because the barrier spacers 412 on the adjacent sub-region B' are spaced apart, a path for the external water and oxygen to pass through the organic light-emitting layer 20 through the organic materials in the notch 410 is effectively extended, and the package reliability is further improved.

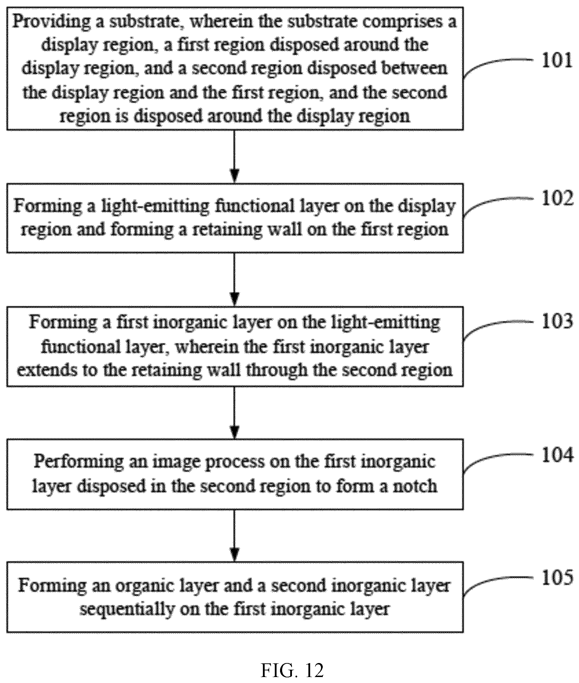

The present invention further provides a manufacturing method of the OLED display panel. Please refer to FIG. 1, FIG. 2, and FIG. 12. The specific manufacturing steps are as follows:
101, providing a substrate, wherein the substrate comprises a display region, a first region disposed around the display region, and a second region disposed between the display region and the first region, and the second region is disposed around the display region.

The substrate 10 may be a polyimide (PI) flexible substrate (polyimide film). The substrate 10 may comprise one or more PI films, which is not limited in the present invention.

102, forming a light-emitting functional layer on the display region and forming a retaining wall on the first region.

The light-emitting functional layer 20 comprises an array layer 21 and a light-emitting layer 22 which are arranged in a stack. Specifically, the array layer 21 comprises, but is not limited to, an active layer 211, a first dielectric insulating layer 212, a gate metal layer 213, a second dielectric insulating layer 214, a source-drain metal layer 215, and a planarization layer 216, which are arranged in a stack. The light emitting layer 22 comprises, but is not limited to, a pixel electrode layer 221, a pixel definition layer 222, a light-emitting material layer 223, and a cathode layer 224, which are arranged in a stack. The array layer 21 and the light-emitting layer 22 are formed on the display region AA in turn. The specific process is the conventional prior art, which is not described thereto.

The retaining wall 30 can be formed by using the same process when forming a certain functional film layer in the light-emitting functional layer 20. For example, when the pixel definition layer 222 is formed in the display region AA, the retaining wall 30 is formed on the same layer in the first region C. Or, when the planarization layer 216 is formed in the display region AA, a part of the retaining wall 30 is formed on the same layer in the first region C, and then when the pixel definition layer 222 is formed on the planarization layer 216, another part of the retaining wall 30 is formed on the same layer in the first region C. That is, the retaining wall 30 is composed of the planarization layer 216 and the pixel definition layer 222 arranged in a stack. This solution can save process and reduce production costs.

103, forming a first inorganic layer on the light-emitting functional layer, wherein the first inorganic layer extends to the retaining wall through the second region.

Specifically, the first inorganic layer 41 may be formed by an evaporation process, a chemical vapor deposition process, or other processes.

104, performing an image process on the first inorganic layer disposed in the second region to form a notch.

Specifically, the first inorganic layer 41 disposed in the second region B may be dry-etched to obtain the notch 410. The specific etching pattern of the notch 410 can be set according to the actual situation, which is not limited thereto.

105, forming an organic layer and a second inorganic layer sequentially on the first inorganic layer.

Specifically, the second inorganic layer 43 may be formed by an evaporation process, a chemical vapor deposition process, or other processes. The organic layer 42 is formed by an inkjet printing process. When the organic layer 42 is formed using the inkjet printing process, the organic materials are inkjet printed on the first inorganic layer 41 disposed in the display region AA. The second inorganic layer 42 extends to the retaining wall 30 through the second region B.

It should be noted that the present invention only uses the thin film packing layer 40 to comprise the first inorganic layer 41, the second inorganic layer 42, and the third inorganic layer 43 as an example for description, but it cannot be construed as limiting the present invention.

In addition, when the first inorganic layer 41 and the second inorganic layer 43 are deposited, the first inorganic layer 41 and/or the second inorganic layer 43 can be extended to the retaining wall 30 and completely cover the retaining wall 30 to further preventing outside water and oxygen from invading into the OLED display panel through the side of the retaining wall 30 away from the display region AA, thereby further improving reliability of the thin film packing layer 40.

In the embodiment of the present invention, the first inorganic layer 41 in the second region B around the display region AA is etched to form the notch 410. The notch 410 is used to contain the flowable organic materials, so that inkjet printed organic materials have a greatly reduced flow velocity at the periphery of the display region AA, and the organic materials are solidified to form the organic layer 42 before overflowing the retaining wall 30, which effectively prevents the organic materials from diffusing and overflowing the retaining wall 30, thereby improving the packaging effect.

## Claims

1. An OLED display panel, comprising se:
a substrate (10) comprising a display region (AA), a first region (C) disposed around the display region (AA), and a second region (B) disposed between the display region (AA) and the first region (C), wherein the second region (B) surrounds the display region (AA);
a light-emitting functional layer (20) disposed on the display region (AA);
a retaining wall (30) disposed on the first region (C); and
a thin film packing layer (40) disposed on the light emitting functional layer (20) and extending to the retaining wall (30) through the second region (B);
wherein the thin film packing layer (40) comprises a first inorganic layer (41), an organic layer (42), and a second inorganic layer (43) disposed in a stack, and a plurality of notches (410) are defined in the first inorganic layer (41) disposed in the second region (B);
wherein all of the notches (410) are filled with material of the organic layer (42);
wherein the second region (B) comprises at least two sub-regions (B') surrounding the display region (AA), the at least two sub-regions (B') comprise a peripheral sub-region close to the display region (AA) and an edge sub-region away from the display region (AA), multiple ones of the notches (410) are defined in the peripheral sub-region, and multiple ones of the notches (410) are defined in the edge sub-region;
wherein all of the notches (410) are spaced from the light-emitting functional layer (20), a bottom of the notch (410) in the peripheral sub-region is spaced from the substrate (10) by a portion of the first inorganic layer (41), and the notches (410) in the edge sub-region extend through the first inorganic layer (41) and into the substrate (10).

2. The OLED display panel as claimed in claim 1, **characterized in that** the notches (410) are disposed at intervals along a direction surrounding the display region (AA).

3. The OLED display panel as claimed in claim 2, **characterized in that** the display region (AA) comprises a first diagonal corner portion (51) and a second diagonal corner portion (52) disposed opposite to each other, and a third diagonal corner portion (53) and a fourth diagonal corner portion (54) disposed opposite to each other; and
the first diagonal corner portion (51), the second diagonal corner portion (52), the third diagonal corner portion (53), and the fourth diagonal corner portion (54) are correspondingly provided with the notches (410), wherein the notches (410) arranged corresponding to the first diagonal corner portion (51), the second diagonal corner portion (52), the third diagonal corner portion (53), and the fourth diagonal corner portion (54) are arc-shaped at locations facing the first diagonal corner portion (51), the second diagonal corner portion (52), the third diagonal corner portion (53), and the fourth diagonal corner portion (54).

4. The OLED display panel as claimed in claim 3, **characterized in that** the display region (AA) further comprises a first end portion (55), a second end portion (56), a third end portion (57), and a fourth end portion (58), the first end portion (55) is disposed between the first diagonal corner portion (51) and the fourth diagonal corner portion (54), the second end portion (56) is disposed between the first diagonal corner portion (51) and the third diagonal corner portion (53), the third end portion (57) is disposed between the third diagonal corner portion (53) and the second diagonal corner portion (52), and the fourth end portion (58) is disposed between the second diagonal corner portion (52) and the fourth diagonal corner portion (54); and
the first end portion (55), the second end portion (56), the third end portion (57), and the fourth end portion (58) are correspondingly provided with the notches (410).

5. The OLED display panel as claimed in claim 1, **characterized in that**
on any of the at least one sub-region (B'), each of barrier spacers (412) is between adjacent notches (410), and the barrier spacers (412) on adjacent sub-regions (B') are spaced apart, wherein the barrier spacers (412) are staggered from each other along a direction surrounding the display region (AA).

6. The OLED display panel as claimed in claim 1, **characterized in that** a thickness of the first inorganic layer (41) is 1 µm to 2 µm, and a thickness of the organic layer (42) is 4 µm to 10 µm.

7. A manufacturing method of an OLED display panel, comprising the following steps:
providing a substrate (10), wherein the substrate (10) comprises a display region (AA) (AA), a first region (C) disposed around the display region (AA), and a second region (B) disposed between the display region (AA) and the first region (C), and the second region (B) is disposed around the display region (AA);
forming a light-emitting functional layer (20) on the display region (AA) and forming a retaining wall (30) on the first region (C);
forming a first inorganic layer (41) on the light-emitting functional layer (20), wherein the first inorganic layer (41) extends to the retaining wall (30) through the second region (B);
performing an image process on the first inorganic layer (41) disposed in the second region (B) to form a plurality of notches (410); and
forming an organic layer (42) and a second inorganic layer (43) sequentially on the first inorganic layer (41);
wherein a plurality of notches (410) are defined in the first inorganic layer (41) disposed in the second region (B), and all of the notches (410) are filled with material of the organic layer (42);
wherein the second region (B) comprises at least two sub-regions (B') surrounding the display region (AA), the at least two sub-regions (B') comprise a peripheral sub-region close to the display region (AA) and an edge sub-region away from the display region (AA), multiple ones of the notches (410) is defined in the peripheral sub-region, and multiple ones of the notches (410) are defined in the edge sub-region;
wherein all of the notches (410) are spaced from the light-emitting functional layer (20), a bottom of the notch (410) in the peripheral sub-region is spaced from the substrate (10) by a portion of the first inorganic layer (41), and the notches (410) in the edge sub-region extend through the first inorganic layer (41) and into the substrate (10).

8. The manufacturing method of the OLED display panel as claimed in claim 7, **characterized in that** the notches (410) are disposed at intervals along a direction surrounding the display region (AA).

9. The manufacturing method of the OLED display panel as claimed in claim 8, **characterized in that** the display region (AA) comprises a first diagonal corner portion (51) and a second diagonal corner portion (52) disposed opposite to each other, and a third diagonal corner portion (53) and a fourth diagonal corner portion (54) disposed opposite to each other; and the first diagonal corner portion (51), the second diagonal corner portion (52), the third diagonal corner portion (53), and the fourth diagonal corner portion (54) are correspondingly provided with the notches (410), wherein the notches (410) arranged corresponding to the first diagonal corner portion (51), the second diagonal corner portion (52), the third diagonal corner portion (53), and the fourth diagonal corner portion (54) are arc-shaped at locations facing the first diagonal corner portion (51), the second diagonal corner portion (52), the third diagonal corner portion (53), and the fourth diagonal corner portion (54).

10. The OLED display panel as claimed in claim 9, **characterized in that** the display region (AA) further comprises a first end portion (55), a second end portion (56), a third end portion (57), and a fourth end portion (58), the first end portion (55) is disposed between the first diagonal corner portion (51) and the fourth diagonal corner portion (54), the second end portion (56) is disposed between the first diagonal corner portion (51) and the third diagonal corner portion (53), the third end portion (57) is disposed between the third diagonal corner portion (53) and the second diagonal corner portion (52), and the fourth end portion (58) is disposed between the second diagonal corner portion (52) and the fourth diagonal corner portion (54); and the first end portion (55), the second end portion (56), the third end portion (57), and the fourth end portion (58) are correspondingly provided with the notches (410).

11. The manufacturing method of the OLED display panel as claimed in claim 7, **characterized in that** on any of the at least one sub-region (B'), each of barrier spacers (412) is between adjacent notches (410), and the barrier spacers (412) on adjacent sub-regions (B') are spaced apart.

12. The manufacturing method of the OLED display panel as claimed in claim 7, **characterized in that** a thickness of the first inorganic layer (41) is 1 µm to 2 µm, and a thickness of the organic layer (42) is 4 µm to 10 µm.

## Patentansprüche

1. Eine OLED-Anzeigetafel, umfassend:
ein Substrat (10), das einen Anzeigebereich (AA), einen ersten Bereich (C), der um den Anzeigebereich (AA) herum angeordnet ist, und einen zweiten Bereich (B) umfasst, der zwischen dem Anzeigebereich (AA) und dem ersten Bereich (C) angeordnet ist, wobei der zweite Bereich (B) den Anzeigebereich (AA) umgibt;
eine auf dem Anzeigebereich (AA) angeordnete lichtemittierende Funktionsschicht (20);
eine Stützwand (30), die im ersten Bereich (C) angeordnet ist; und
eine Dünnschicht-Packungsschicht (40), die auf der lichtemittierenden Funktionsschicht (20) angeordnet ist und sich durch den zweiten Bereich (B) bis zur Stützwand (30) erstreckt;
wobei die Dünnschicht-Packungsschicht (40) eine erste anorganische Schicht (41), eine organische Schicht (42) und eine zweite anorganische Schicht (43) umfasst, die in einem Stapel angeordnet sind, und wobei in der ersten anorganischen Schicht (41), die im zweiten Bereich (B) angeordnet ist, mehrere Aussparungen (410) ausgebildet sind; wobei alle Aussparungen (410) mit Material der organischen Schicht (42) gefüllt sind;
wobei der zweite Bereich (B) mindestens zwei den Anzeigebereich (AA) umgebende Teilbereiche (B') umfasst, wobei die mindestens zwei Teilbereiche (B') einen peripheren Teilbereich nahe dem Anzeigebereich (AA) und einen vom Anzeigebereich (AA) entfernten Randteilbereich umfassen, wobei mehrere der Aussparungen (410) im peripheren Teilbereich definiert sind und mehrere der Aussparungen (410) im Randteilbereich definiert sind;
wobei alle Aussparungen (410) von der lichtemittierenden Funktionsschicht (20) beabstandet sind, ein Boden der Aussparung (410) im peripheren Teilbereich durch einen Abschnitt der ersten anorganischen Schicht (41) vom Substrat (10) beabstandet ist, und die Aussparungen (410) im Randteilbereich sich durch die erste anorganische Schicht (41) hindurch bis in das Substrat (10) erstrecken.

2. OLED-Anzeigetafel nach Anspruch 1, **dadurch gekennzeichnet, dass** die Aussparungen (410) in Abständen entlang einer den Anzeigebereich (AA) umgebenden Richtung angeordnet sind.

3. OLED-Anzeigetafel nach Anspruch 2, **dadurch gekennzeichnet, dass** der Anzeigebereich (AA) einen ersten diagonalen Eckabschnitt (51) und einen zweiten diagonalen Eckabschnitt (52), die einander gegenüberliegen, sowie einen dritten diagonalen Eckabschnitt (53) und einen vierten diagonalen Eckabschnitt (54), die einander gegenüberliegen, umfasst; und
der erste diagonale Eckabschnitt (51), der zweite diagonale Eckabschnitt (52), der dritte diagonale Eckabschnitt (53) und der vierte diagonale Eckabschnitt (54) entsprechend mit den Aussparungen (410) versehen sind, wobei die Aussparungen (410), die entsprechend dem ersten diagonalen Eckabschnitt (51), dem zweiten diagonalen Eckabschnitt (52), dem dritten diagonalen Eckabschnitt (53) und dem vierten diagonalen Eckabschnitt (54) angeordneten Aussparungen (410) an den Stellen, die dem ersten diagonalen Eckabschnitt (51), dem zweiten diagonalen Eckabschnitt (52), dem dritten diagonalen Eckabschnitt (53) und dem vierten diagonalen Eckabschnitt (54) zugewandt sind, bogenförmig sind.

4. OLED-Anzeigetafel nach Anspruch 3, **dadurch gekennzeichnet, dass** der Anzeigebereich (AA) ferner einen ersten Endabschnitt (55), einen zweiten Endabschnitt (56), einen dritten Endabschnitt (57) und einen vierten Endabschnitt (58) umfasst, wobei der erste Endabschnitt (55) zwischen dem ersten diagonalen Eckabschnitt (51) und dem vierten diagonalen Eckabschnitt (54) angeordnet ist, der zweite Endabschnitt (56) zwischen dem ersten diagonalen Eckabschnitt (51) und dem dritten diagonalen Eckabschnitt (53) angeordnet ist, der dritte Endabschnitt (57) zwischen dem dritten diagonalen Eckabschnitt (53) und dem zweiten diagonalen Eckabschnitt (52) angeordnet ist und der vierte Endabschnitt (58) zwischen dem zweiten diagonalen Eckabschnitt (52) und dem vierten diagonalen Eckabschnitt (54) angeordnet ist; und
der erste Endabschnitt (55), der zweite Endabschnitt (56), der dritte Endabschnitt (57) und der vierte Endabschnitt (58) sind entsprechend mit den Aussparungen (410) versehen.

5. OLED-Anzeigetafel nach Anspruch 1, **dadurch gekennzeichnet, dass** in jedem der mindestens einen Teilbereich (B') jeder der Barriereabstandshalter (412) zwischen benachbarten Aussparungen (410) angeordnet ist, und die Barriereabstandshalter (412) auf benachbarten Teilbereichen (B') voneinander beabstandet sind, wobei die Barriereabstandshalter (412) entlang einer den Anzeigebereich (AA) umgebenden Richtung versetzt zueinander angeordnet sind.

6. OLED-Anzeigetafel nach Anspruch 1, **dadurch gekennzeichnet, dass** die Dicke der ersten anorganischen Schicht (41) 1 µm bis 2 µm beträgt und die Dicke der organischen Schicht (42) 4 µm bis 10 µm beträgt.

7. Herstellungsverfahren für die OLED-Anzeigetafel, das die folgenden Schritte umfasst:
Bereitstellen eines Substrats (10), wobei das Substrat (10) einen Anzeigebereich (AA), einen ersten Bereich (C), der um den Anzeigebereich (AA) herum angeordnet ist, und einen zweiten Bereich (B) umfasst, der zwischen dem Anzeigebereich (AA) und dem ersten Bereich (C) angeordnet ist, wobei der zweite Bereich (B) um den Anzeigebereich (AA) herum angeordnet ist;
Bilden einer lichtemittierenden Funktionsschicht (20) auf dem Anzeigebereich (AA) und Bilden einer Stützwand (30) auf dem ersten Bereich (C);
bilden einer ersten anorganischen Schicht (41) auf der lichtemittierenden Funktionsschicht (20), wobei sich die erste anorganische Schicht (41) durch den zweiten Bereich (B) hindurch bis zur Stützwand (30) erstreckt;
Durchführen eines Bildverarbeitungsvorgangs an der ersten anorganischen Schicht (41), die im zweiten Bereich (B) angeordnet ist, um eine Vielzahl von Aussparungen (410) zu bilden; und
Aufbringen einer organischen Schicht (42) und einer zweiten anorganische Schicht (43) auf der ersten anorganischen Schicht (41) nacheinander;
wobei der zweite Bereich (B) mindestens zwei den Anzeigebereich (AA) umgebende Teilbereiche (B') umfasst, die mindestens zwei Teilbereiche (B') einen peripheren Teilbereich nahe dem Anzeigebereich (AA) und einen Randteilbereich entfernt vom Anzeigebereich (AA) umfassen, wobei mindestens eine der Aussparungen (410) im peripheren Teilbereich definiert ist und mehrere der Aussparungen (410) im Randteilbereich definiert sind;
wobei alle Aussparungen (410) von der lichtemittierenden Funktionsschicht (20) beabstandet sind, wobei ein Boden der Aussparung (410) im Randbereich durch einen Abschnitt der ersten anorganischen Schicht (41) vom Substrat (10) beabstandet ist, und sich die Aussparungen (410) im Randbereich durch die erste anorganische Schicht (41) hindurch bis in das Substrat (10) erstrecken.

8. Herstellungsverfahren für die OLED-Anzeigetafel nach Anspruch 7, **dadurch gekennzeichnet, dass** die Aussparung (410) in Abständen entlang einer den Anzeigebereich (AA) umgebenden Richtung angeordnet ist.

9. Herstellungsverfahren für die OLED-Anzeigetafel nach Anspruch 8, **dadurch gekennzeichnet, dass** der Anzeigebereich (AA) einen ersten diagonalen Eckabschnitt (51) und einen zweiten diagonalen Eckabschnitt (52), die einander gegenüberliegen, sowie einen dritten diagonalen Eckabschnitt (53) und einen vierten diagonalen Eckabschnitt (54), die einander gegenüberliegen, umfasst, und der erste diagonale Eckabschnitt (51) und der zweite diagonale Eckabschnitt (52) sowie der dritte diagonale Eckabschnitt (53) und der vierte diagonale Eckabschnitt (54) jeweils mit Aussparungen (410) versehen sind, wobei die Aussparungen (410), die entsprechend dem ersten diagonalen Eckabschnitt (51), dem zweiten diagonalen Eckabschnitt (52), dem dritten diagonalen Eckabschnitt (53) und dem vierten diagonalen Eckabschnitt (54) an den Stellen, die dem ersten diagonalen Eckabschnitt (51), dem zweiten diagonalen Eckabschnitt (52), dem dritten diagonalen Eckabschnitt (53) und dem vierten diagonalen Eckabschnitt (54) zugewandt sind, bogenförmig ausgebildet sind.

10. OLED-Anzeigetafel nach Anspruch 9, **dadurch gekennzeichnet, dass** der Anzeigebereich (AA) ferner einen ersten Endabschnitt (55), einen zweiten Endabschnitt (56), einen dritten Endabschnitt (57) und einen vierten Endabschnitt (58) umfasst, wobei der erste Endabschnitt (55) zwischen dem ersten diagonalen Eckabschnitt (51) und dem vierten diagonalen Eckabschnitt (54) angeordnet ist, der zweite Endabschnitt (56) zwischen dem ersten diagonalen Eckabschnitt (51) und dem dritten diagonalen Eckabschnitt (53) angeordnet ist, der dritte Endabschnitt (57) zwischen dem dritten diagonalen Eckabschnitt (53) und dem zweiten diagonalen Eckabschnitt (52) angeordnet ist, und der vierte Endabschnitt (58) zwischen dem zweiten diagonalen Eckabschnitt (52) und dem vierten diagonalen Eckabschnitt (54) angeordnet ist; und der erste Endabschnitt (55), der zweite Endabschnitt (56), der dritte Endabschnitt (57) und der vierte Endabschnitt (58) entsprechend mit den Aussparungen (410) versehen sind.

11. Herstellungsverfahren für die OLED-Anzeigetafel nach Anspruch 7, **dadurch gekennzeichnet, dass** in jedem der mindestens einen Teilbereich (B') jeweils ein Barriereabstandshalter (412) zwischen benachbarten Aussparungen (410) angeordnet ist und die Barriereabstandshalter (412) in benachbarten Teilbereichen (B') voneinander beabstandet sind.

12. Herstellungsverfahren für die OLED-Anzeigetafel nach Anspruch 7, **dadurch gekennzeichnet, dass** die Dicke der ersten anorganischen Schicht (41) 1 µm bis 2 µm beträgt und die Dicke der organischen Schicht (42) 4 µm bis 10 µm beträgt.

## Revendications

1. Panneau d'affichage OLED, comprenant :
un substrat (10) comprenant une zone d'affichage (AA), une première zone (C) disposée autour de la zone d'affichage (AA), et une deuxième zone (B) disposée entre la zone d'affichage (AA) et la première zone (C), la deuxième zone (B) entourant la zone d'affichage (AA) ;
une couche fonctionnelle électroluminescente (20) disposée sur la zone d'affichage (AA) ;
une paroi de retenue (30) disposée dans la première zone (C) ; et
une couche de remplissage à film mince (40) disposée sur la couche fonctionnelle électroluminescente (20) et s'étendant jusqu'à la paroi de retenue (30) en passant par la deuxième zone (B) ;
dans lequel la couche de remplissage à film mince (40) comprend une première couche inorganique (41), une couche organique (42) et une deuxième couche inorganique (43) disposées en empilement, et une pluralité d'encoches (410) sont définies dans la première couche inorganique (41) située dans la deuxième zone (B) ;
dans lequel toutes les encoches (410) sont remplies de matériau de la couche organique (42) ; dans lequel la deuxième zone (B) comprend au moins deux sous-régions (B') entourant la zone d'affichage (AA), les au moins deux sous-régions (B') comprennent une sous-région périphérique proche de la zone d'affichage (AA) et une sous-région de bord éloignée de la zone d'affichage (AA), plusieurs des encoches (410) sont définies dans la sous-région périphérique, et plusieurs des encoches (410) sont définies dans la sous-région de bord ;
dans lequel toutes les encoches (410) sont espacées de la couche fonctionnelle électroluminescente (20), le fond d'une encoche (410) située dans la sous-région périphérique étant espacé du substrat (10) par une partie de la première couche inorganique (41), et les encoches (410) situées dans la sous-région de bord s'étendent à travers la première couche inorganique (41) jusqu'au substrat (10).

2. Panneau d'affichage OLED selon la revendication 1, **caractérisé en ce que** les encoches (410) sont disposées à intervalles réguliers dans une direction entourant la zone d'affichage (AA).

3. Panneau d'affichage OLED selon la revendication 2, **caractérisé en ce que** la zone d'affichage (AA) comprend une première partie d'angle diagonale (51) et une deuxième partie d'angle diagonale (52) disposées en vis-à-vis l'une de l'autre, ainsi qu'une troisième partie d'angle diagonale (53) et une quatrième partie d'angle diagonale (54) disposées en vis-à-vis l'une de l'autre ; et
la première partie d'angle diagonale (51), la deuxième partie d'angle diagonale (52), la troisième partie d'angle diagonale (53) et la quatrième partie d'angle diagonale (54) sont pourvues, de manière correspondante, d'encoches (410), les encoches (410) disposées en correspondance avec la première partie d'angle diagonale (51), la deuxième partie d'angle diagonale (52), la troisième partie d'angle diagonale (53) et la quatrième partie d'angle diagonale (54) sont en forme d'arc aux emplacements faisant face à la première partie d'angle diagonale (51), à la deuxième partie d'angle diagonale (52), à la troisième partie d'angle diagonale (53) et à la quatrième partie d'angle diagonale (54).

4. Panneau d'affichage OLED selon la revendication 3, **caractérisé en ce que** la zone d'affichage (AA) comprend en outre une première partie d'extrémité (55), une deuxième partie d'extrémité (56), une troisième partie d'extrémité (57) et une quatrième partie d'extrémité (58), la première partie d'extrémité (55) étant disposée entre la première partie d'angle diagonale (51) et la quatrième partie d'angle diagonale (54), la deuxième partie d'extrémité (56) est disposée entre la première partie d'angle diagonale (51) et la troisième partie d'angle diagonale (53), la troisième partie d'extrémité (57) est disposée entre la troisième partie d'angle diagonale (53) et la deuxième partie d'angle diagonale (52), et la quatrième partie d'extrémité (58) est disposée entre la deuxième partie d'angle diagonale (52) et la quatrième partie d'angle diagonale (54) ; et
la première partie d'extrémité (55), la deuxième partie d'extrémité (56), la troisième partie d'extrémité (57) et la quatrième partie d'extrémité (58) sont pourvues, chacune, d'encoches (410) correspondantes.

5. Panneau d'affichage OLED selon la revendication 1, **caractérisé en ce que**, sur l'une quelconque de la au moins une sous-région (B'), chacune des entretoises de barrière (412) est située entre des encoches adjacentes (410), et les entretoises de barrière (412) situées sur des sous-régions adjacentes (B') sont espacées les unes des autres, les entretoises de barrière (412) étant décalées les unes par rapport aux autres selon une direction entourant la zone d'affichage (AA).

6. Panneau d'affichage OLED selon la revendication 1, **caractérisé en ce que** l'épaisseur de la première couche inorganique (41) est comprise entre 1 µm et 2 µm, et l'épaisseur de la couche organique (42) est comprise entre 4 µm et 10 µm.

7. Procédé de fabrication d'un panneau d'affichage OLED, comprenant les étapes suivantes :
fournir un substrat (10), dans lequel le substrat (10) comprend une zone d'affichage (AA), une première zone (C) disposée autour de la zone d'affichage (AA), et une deuxième zone (B) disposée entre la zone d'affichage (AA) et la première zone (C), la deuxième zone (B) étant disposée autour de la zone d'affichage (AA) ;
en formant une couche fonctionnelle électroluminescente (20) sur la zone d'affichage (AA) et en formant une paroi de retenue (30) sur la première zone (C) ;
en formant une première couche inorganique (41) sur la couche fonctionnelle électroluminescente (20), la première couche inorganique (41) s'étendant jusqu'à la paroi de retenue (30) en passant par la deuxième zone (B) ;
réaliser un traitement d'image sur la première couche inorganique (41) disposée dans la deuxième zone (B) afin de former une pluralité d'encoches (410) ; et
en formant successivement une couche organique (42) et une deuxième couche inorganique (43) sur la première couche inorganique (41) ;
dans lequel la deuxième zone (B) comprend au moins deux sous-régions (B') entourant la zone d'affichage (AA), lesdites au moins deux sous-régions (B') comprennent une sous-région périphérique proche de la zone d'affichage (AA) et une sous-région de bord éloignée de la zone d'affichage (AA), au moins l'une des encoches (410) étant définie dans la sous-région périphérique, et plusieurs des encoches (410) étant définies dans la sous-région de bord ;
dans lequel toutes les encoches (410) sont espacées de la couche fonctionnelle électroluminescente (20), le fond d'une encoche (410) située dans la sous-région périphérique étant espacé du substrat (10) par une partie de la première couche inorganique (41), et les encoches (410) situées dans la sous-région de bord s'étendent à travers la première couche inorganique (41) jusqu'au substrat (10).

8. Procédé de fabrication d'un panneau d'affichage OLED selon la revendication 7, **caractérisé en ce que** l'encoche (410) est disposée à intervalles réguliers le long d'une direction entourant la zone d'affichage (AA).

9. Procédé de fabrication d'un panneau d'affichage OLED selon la revendication 8, **caractérisé en ce que** la zone d'affichage (AA) comprend une première partie d'angle diagonale (51) et une deuxième partie d'angle diagonale (52) disposées l'une en face de l'autre, ainsi qu'une troisième partie d'angle diagonale (53) et une quatrième partie d'angle diagonale (54) disposées l'une en face de l'autre, et la première partie d'angle diagonale (51) et la deuxième partie d'angle diagonale (52), la troisième partie d'angle diagonale (53) et la quatrième partie d'angle diagonale (54) sont pourvues de manière correspondante d'encoches (410), les encoches (410) disposées en correspondance avec la première partie d'angle diagonale (51), la deuxième partie d'angle diagonale (52), la troisième partie d'angle diagonale (53) et la quatrième partie d'angle diagonale (54) sont en forme d'arc aux emplacements faisant face à la première partie d'angle diagonale (51), à la deuxième partie d'angle diagonale (52), à la troisième partie d'angle diagonale (53) et à la quatrième partie d'angle diagonale (54).

10. Panneau d'affichage OLED selon la revendication 9, **caractérisé en ce que** la zone d'affichage (AA) comprend en outre une première partie d'extrémité (55), une deuxième partie d'extrémité (56), une troisième partie d'extrémité (57) et une quatrième partie d'extrémité (58), la première partie d'extrémité (55) étant disposée entre la première partie d'angle diagonale (51) et la quatrième partie d'angle diagonale (54), la deuxième partie d'extrémité (56) est disposée entre la première partie d'angle diagonale (51) et la troisième partie d'angle diagonale (53), la troisième partie d'extrémité (57) est disposée entre la troisième partie d'angle diagonale (53) et la deuxième partie d'angle diagonale (52), et la quatrième partie d'extrémité (58) est disposée entre la deuxième partie d'angle diagonale (52) et la quatrième partie d'angle diagonale (54) ; et la première partie d'extrémité (55), la deuxième partie d'extrémité (56), la troisième partie d'extrémité (57) et la quatrième partie d'extrémité (58) sont pourvues, de manière correspondante, d'encoches (410).

11. Procédé de fabrication d'un panneau d'affichage OLED selon la revendication 7, **caractérisé en ce que**, sur l'une quelconque de la au moins une sous-région (B'), chacune des entretoises de barrière (412) est située entre des encoches adjacentes (410), et les entretoises de barrière (412) situées sur des sous-régions adjacentes (B') sont espacées les unes des autres.

12. Procédé de fabrication d'un panneau d'affichage OLED selon la revendication 7, **caractérisé en ce que** l'épaisseur de la première couche inorganique (41) est comprise entre 1 µm et 2 µm, et l'épaisseur de la couche organique (42) est comprise entre 4 µm et 10 µm.
